Europäisches Patentamt

European Patent Office

Office européen des brevets

(19)

(11) Publication number: **0 449 477 A1**

(12) **EUROPEAN PATENT APPLICATION**

(21) Application number: **91302311.5**

(22) Date of filing: **18.03.91**

(51) Int. Cl.⁵: **H01L 27/146, H01L 31/0216**

(30) Priority: **26.03.90 JP 77775/90**

(43) Date of publication of application:
**02.10.91 Bulletin 91/40**

(84) Designated Contracting States:
**DE FR GB**

(71) Applicant: **SEIKO INSTRUMENTS INC.**
**31-1, Kameido 6-chome Koto-ku**
**Tokyo 136 (JP)**

(72) Inventor: **Machida, Satoshi**
**c/o Seiko Instruments Inc., 31-1, Kameido**
**6-chome**
**Koto-ku, Tokyo (JP)**
Inventor: **Kawahara, Yukito**
**c/o Seiko Instruments Inc., 31-1, Kameido**
**6-chome**
**Koto-ku, Tokyo (JP)**
Inventor: **Mukainakano, Hiroshi**
**c/o Seiko Instruments Inc., 31-1, Kameido**
**6-chome**
**Koto-ku, Tokyo (JP)**

(74) Representative: **Miller, Joseph et al**
**J. MILLER & CO. Lincoln House 296-302 High**
**Holborn**
**London WC1V 7JH (GB)**

(54) **Colour image sensor.**

(57) The present invention provides a colour image sensor comprising a plurality of image sensor chips (13) arranged linearly in a continuous line. A transparent plate (15) having a plurality of colour filters (18, 19, 20) formed thereon in stripes is disposed over the line of image sensor chips such that each colour filter has a uniform spectral transmittance throughout the span of the line of chips, whereby a uniform read image may be obtained without the need for colour compensation.

EP 0 449 477 A1

# FIG. 2

VERTICAL
SCANNING
DIRECTION

The present invention relates to a colour image sensor for use in colour image scanners and colour copy machines and the like.

Colour image scanners and colour copy machines have recently been developed. Generally, a colour image sensor is provided in these apparatus for sensing an image in an input operation. Conventionally, the colour image sensor comprises a plurality of image sensor chips staggered in a linear direction and provided with colour filters.

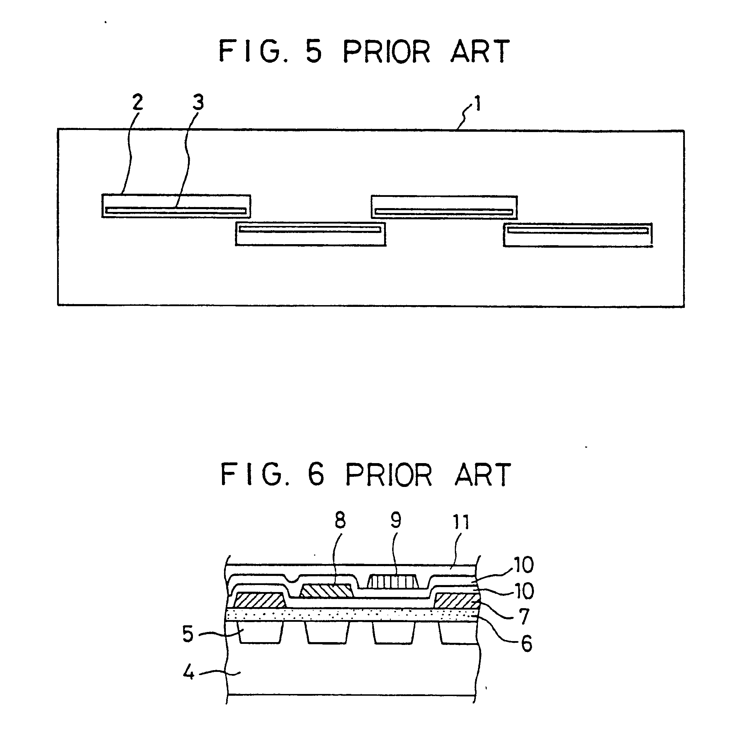

Figure 5 shows a plan view of such a colour image sensor. A plurality of image sensor chips 2 are arranged on a substrate 1 in staggered relation to each other. Each image sensor chip 2 includes picture elements covered by a colour filter 3. The image sensor has a width-wise span set to be slightly greater than the width of a sheet of recording paper.

Figure 6 shows a sectional view of a light receiving portion of one of the image sensor chips 2. Photo-detecting elements 5 are formed in a semiconductor substrate 4 of the chip. The semi-conductor substrate 4 has formed sequentially thereon a levelling layer 6, a first colour filter 7, a second colour filter 8, a third colour filter 9 and a protective layer 11. The different colour filters are separated from each other by separating layers 10. This colour image sensor operates to separate a colour image into three primary colour tones to produce corresponding electric signals.

However, as shown in Figure 6, in the conventional colour image sensor, the colour filter formed on the semi-conductor substrate has at least a seven layer structure, resulting in drawbacks such as a complicated construction and fabrication process.

Moreover, as shown in Figure 5, the image sensor chips 2 are arranged in staggered relation such that linear reading arrays of the image sensor chips are offset from one another by several pixels, thereby requiring a complicated signal processing circuit to compensate for the offset. In order to avoid the need for staggering the chips, it would be advantageous for the linear colour filter to extend to an edge of each image sensor chip 2. However, it is not possible for the colour filter to have a uniform spectral transmittance at the edge portion of each chip.

Further, individual colour filters among the different image sensor chips have a variable spectral transmittance, thereby causing such drawbacks as a read image being degraded or dis-continuous at junctions between adjacent image sensor chips 2, and stripe defects occurring at junctions. In order to eliminate these drawbacks, a signal processing circuit is utilised to compensate for colour tone differences generated at each chip. However, such compensation does not work to a practically acceptable degree.

It is an object of the present invention to avoid these drawbacks of the prior art by providing a colour image sensor operative to produce a uniform image output while having a simplified construction. Such a sensor is also connectable to a simplified reading circuit.

According to the present invention, there is provided a colour image sensor comprising a plurality of image sensor chips having an array of pixels, and a colour filter arrangement provided on the image sensor chips such that incident light irradiates the array of pixels there-through, characterised in that the image sensor chips are arranged linearly in a line, and in that the colour filter arrangement comprises a transparent plate disposed on the image sensor chips and having formed thereon a colour filter of different tones extending along the line of the chips.

According to the invention, a plurality of image sensor chips are arranged linearly to constitute an image sensor. This image sensor is provided with a transparent plate formed with a colour filter in superposed alignment on pixels or picture elements formed on the chips so as to obtain a uniform read image using a simplified structure.

In the colour image sensor constructed as described above, a reading line array is perfectly linearly arranged throughout the entire span of the chips. Therefore, it is not necessary to adjust a reading timing offset chip-by-chip, thereby simplifying an external signal processing circuit employed with the sensor. Further, the colour filter is continuously formed on a single transparent plate such that the colour filter has a uniform spectral transmittance throughout the entire span of the colour image sensor, thereby obtaining a uniform read image without colour compensation for individual chips.

The invention is described further, by way of example, with reference to the accompanying drawings, in which:-

Figure 1 is a plan view showing one embodiment of a colour image sensor according to the present invention;

Figure 2 is an enlarged partial plan view showing a junction portion between adjacent image sensor chips in the colour image sensor of Figure 1;

Figure 3 is a sectional view of the colour image sensor of Figure 1;

Figure 4 is a sectional view of an optical image reader utilising the colour image sensor of Figure 1;

Figure 5 is a plan view of a conventional colour image sensor; and

Figure 6 is a sectional view of a light receiving portion of an image sensor chip of the conventional colour image sensor of Figure 5.

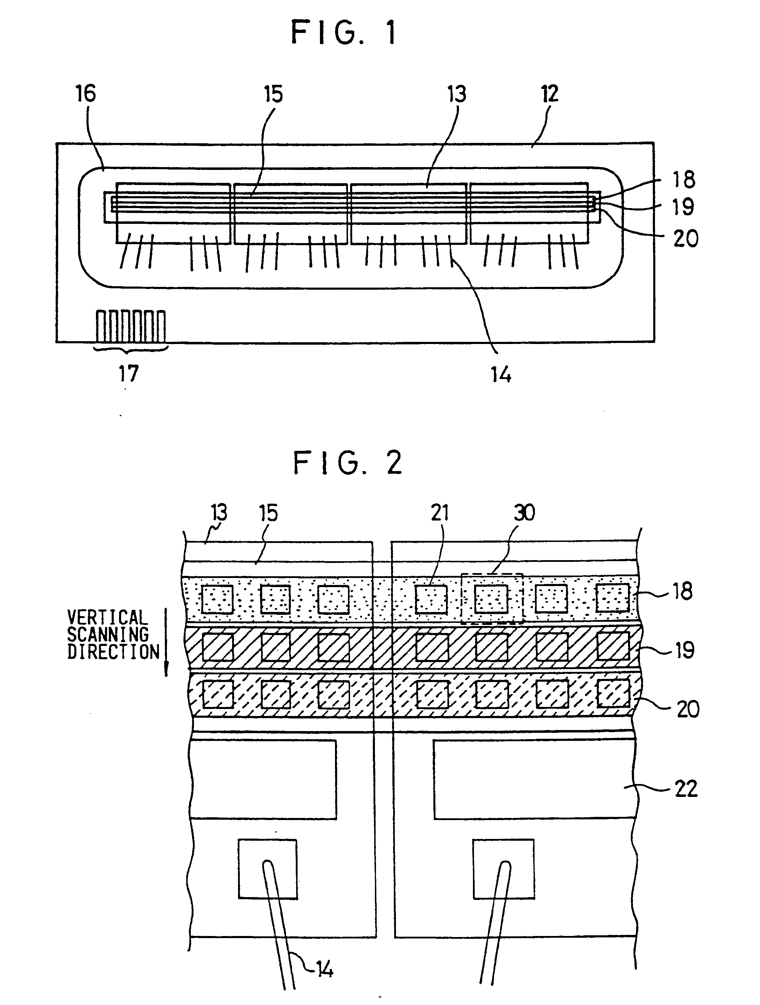

Figure 1 is a plan view of a colour image sensor according to the invention. A plurality of image sensor chips 13 are linearly arranged on a substrate 12. The image sensor chips 13 are electrically connected to the substrate 12 through bonding wires 14. The substrate 12 is formed with terminals 17 for connection to an external circuit. A transparent plate 15 is formed with three colour filters 18, 19 and 20 arranged in stripes, and is fixedly mounted over the image sensor chips 13 by means of a transparent resin 16.

Figure 2 is an enlarged partial plan view of a junction portion between adjacent image sensor chips 13 of the colour image sensor according to the invention. The transparent plate 15 is composed of glass or a plastics material, and has formed on its under surface the colour filter 18 of a first primary colour tone, the colour filter 19 of a second primary colour tone, and the colour filter 20 of a third primary colour tone in a stripe configuration. Each of the colour filters 18, 19 and 20 of the three primary colour tones is formed to extend throughout the entire span of an image reading line, by means of printing or laminating colour filter films on the transparent plate 15. Each of the colour filters has a uniform spectral transmittance throughout the entire span of the image reading line.

Each individual image sensor chip 13 has formed thereon an array of photo-detecting elements 21 and a scanning circuit 22. The photo-detecting elements 21 are arranged in three rows, in the vertical scanning direction or line feeding direction, such that the three rows are registered with the corresponding three lines formed by the colour filters 18, 19 and 20 on the transparent plate 15. By means of such arrangement, the first row of the photo-detecting elements 21 is disposed under the first colour filter 18 to produce a colour signal representing the first colour tone. In a similar manner, the second row of photo-detecting elements is disposed under the second colour filter 19 and the the third row of photo-detecting elements is disposed under the third colour filter 20 whereby, with the first row, to produce three colour signals together. The image sensor chips 13 are highly precisely aligned relative to each other such that each photo-detecting element 21 registers accurately with the corresponding colour filter.

In the embodiment shown in Figure 2, the array of the photo-detecting elements 21 has a given pitch identical to that of pixels or picture elements 30 in the vertical scanning direction or line feed direction. A delay due to this pitch can be compensated by a line memory or buffer memory provided in the image sensor chip 13. Otherwise, the three rows of photo-detecting elements and the three colour filters may be formed compactly within one pitch of the pixels.

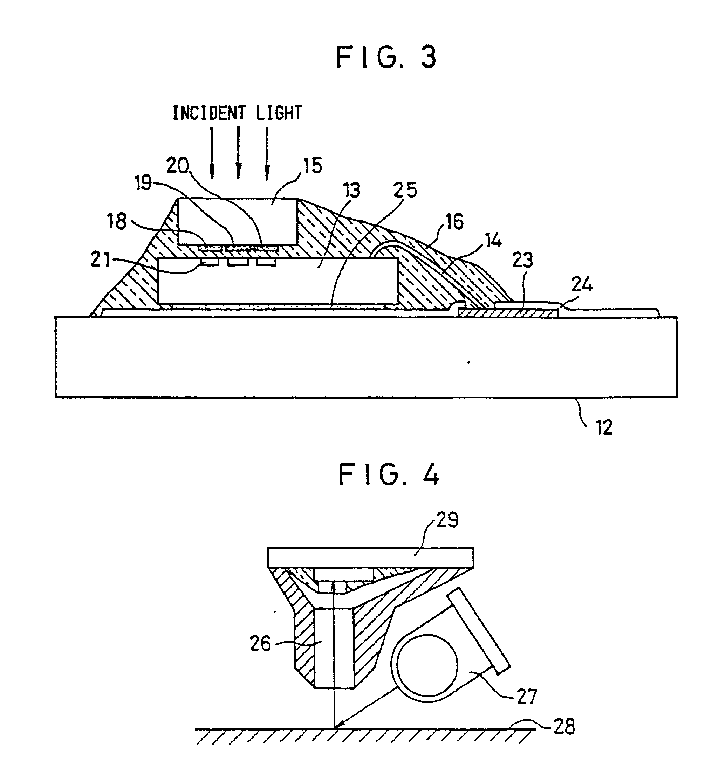

Figure 3 is a sectional view of the colour image sensor, taken along the vertical scanning direction. A lead pattern 23 is formed on the substrate 12, and is covered by a protective film 24 except in a bonding pad area. The image sensor chip 13 is fixed to the substrate 12 by means of die bonding resin 25. The transparent resin 16 is partly interposed between the photo-detecting elements 21 formed in the surface of the image sensor chip 13 and the colour filters 18, 19 and 20 to protect the colour filters. Further, the transparent resin 16 extends so as to fix the transparent plate 15 in place and to protect the bonding wires 14.

Figure 4 is a sectional view of an optical image reader including the colour image sensor according to the present invention. A fluorescent lamp 27 is disposed to irradiate a document 28. A part of the incident light is reflected by the document 28 and is then focused on a receiving surface of the colour image sensor through a collimating lens 26.

As described above, this invention can provide a colour image sensor having a simplified construction, which is effective to produce an image signal of uniform quality.

## Claims

1. A colour image sensor comprising a plurality of image sensor chips (13) having an array of pixels, and a colour filter arrangement (18, 19, 20) provided on the image sensor chips such that incident light irradiates the array of pixels there-through, characterised in that the image sensor chips are arranged linearly in a line, and in that the colour filter arrangement comprises a transparent plate (15) disposed on the image sensor chips and having formed thereon a colour filter (18, 19, 20) of different tones extending along the line of the chips.

2. A colour image sensor according to claim 1 characterised in that the array of pixels comprises a plurality of rows of pixels, and in that the colour filter comprises a plurality of stripes of different colour tone films (18, 19, 20) which are superposed respectively in registration with the rows of pixels.

3. A colour image sensor according to claim 1 or 2 characterised in that a transparent resin (16) is provided as a filling between the array of pixels of the image sensor chips and the transparent plate.

4. A colour image sensor according to claim 1, 2 or 3 characterised in that each image sensor chip contains a line memory.

# FIG. 1

# FIG. 2

VERTICAL
SCANNING
DIRECTION

# F I G. 3

INCIDENT LIGHT

# F I G. 4

# FIG. 5 PRIOR ART

# FIG. 6 PRIOR ART

EP 0 449 477 A1

## European Patent Office

### EUROPEAN SEARCH REPORT

Application Number

EP 91 30 2311

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN vol. 10, no. 175 (E-413)(2231), 20 June 1986; & JP - A - 61024271 (NIPPON DENKI K.K.) 01.02.1986 <br> * whole document * <br> --- | 1-4 | H 01 L 27/146 <br> H 01 L 31/0216 |
| A | EP-A-0 289 044 (TOSHIBA) <br> * abstract; figure 2 * <br> --- | 1-4 | |
| A | EP-A-0 173 413 (TOSHIBA) <br> * abstract; claims 1-8; figures 1,2 * <br> ----- | 1-4 | |

TECHNICAL FIELDS SEARCHED (Int. Cl.5)

H 01 L

The present search report has been drawn up for all claims

| Place of search | Date of completion of the search | Examiner |
|---|---|---|
| BERLIN | 05-06-1991 | MUNNIX S J G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

8